(19) **Europäisches Patentamt**

**European Patent Office**

**Office européen des brevets**

(11) **EP 0 783 169 B1**

(12) **EUROPÄISCHE PATENTSCHRIFT**

(45) Veröffentlichungstag und Bekanntmachung des Hinweises auf die Patenterteilung:
**19.03.2003  Patentblatt 2003/12**

(51) Int Cl.7: **G11C 17/12**, G11C 16/04

(21) Anmeldenummer: **96119168.1**

(22) Anmeldetag: **28.11.1996**

(54) **Matrix-Speicher (Virtual Ground)**

Virtual ground array memory

Matrice mémoire à masse virtuelle

(84) Benannte Vertragsstaaten:
**DE FR GB IT**

(30) Priorität: **08.01.1996  DE 19600424**

(43) Veröffentlichungstag der Anmeldung:
**09.07.1997   Patentblatt 1997/28**

(73) Patentinhaber: **Infineon Technologies AG**
**81669 München (DE)**

(72) Erfinder:
• **Basse, Paul-Werner, von**
**82515 Wolfratshausen (DE)**
• **Thewes, Roland, Dr.**
**82194 Gröbenzell (DE)**
• **Schmitt-Landsiedel, Doris, Dr.**
**85521 Ottobrunn (DE)**
• **Bollu, Michael, Dr.**
**81671 München (DE)**

(74) Vertreter: **Epping Hermann & Fischer**
**Ridlerstrasse 55**
**80339 München (DE)**

(56) Entgegenhaltungen:
US-A- 4 021 781      US-A- 5 117 389
US-A- 5 379 254      US-A- 5 663 903

**Beschreibung**

NOR-Speicherzellen mit eingeprägter Masse (virtual ground) sind die einfachsten Speicherzellen in ROM-Matrix-Speichern. Sie bestehen aus einem MOS-Transistor, in dem die Information von einem Bit gespeichert wird durch die Höhe der Schwellenspannung (threshold voltage), d. h. dadurch, daß beim Anlegen eines bestimmten Potentials an das Gate zwischen Source und Drain ein Strom fließt je nachdem, ob eine "0" oder eine "1" gespeichert ist. Die Speicherzellen sind jeweils zwischen zwei Bitleitungen angeordnet und werden zeilenweise durch Wortleitungen angesteuert.

Vor dem Auslesen einer Speicherzelle werden alle Bitleitungen auf ein Potential vorgeladen, z. B. auf die Versorgungsspannung $V_{DD}$. Alle Wortleitungen liegen auf niedrigem Potential, z. B. auf der Versorgungsspannung $V_{SS}$. Beim Auslesen einer Speicherzelle wird die Wortleitung, an der die auszulesende Zelle liegt, auf hohes Potential angehoben und die Bitleitung, an der die auszulesende Zelle liegt, auf niedriges Potential abgesenkt. Enthält die Zelle einen MOSFET mit niedriger Schwelle, wird dieser MOSFET leitend und entlädt über die auf niedrigem Potential liegende Bitleitung die benachbarten Bitleitungen, die sich noch auf hohem Potential befanden. Enthält die Zelle dagegen einen MOSFET mit hoher Schwellenspannung, so bleibt der MOSFET gesperrt und die benachbarten Bitleitungen ändern ihr Potential nicht.

Wenn nicht nur die auszulesende Zelle, sondern alle benachbarten Zellen an der gleichen Wortleitung MOS-Transistoren niedriger Schwelle enthalten, dann werden auch diese benachbarten MOS-Transistoren nacheinander leitend und verbinden alle benachbarten Bitleitungen untereinander. Es wird also nicht nur eine Bitleitung entladen, sondern nach ausreichend langer Zeit das gesamte Zellenfeld. Diese Anordnung hat also zwei Nachteile. Zum einen ist die Auslesezeit abhängig von der Information der Nachbarzelle; zum anderen sind bei fester Bewertungszeit die Signalpegel abhängig von der Information der Nachbarzellen.

Um die obengenannten Schwierigkeiten zu umgehen, wird nach dem Aufladen der Bitleitungen die Wortleitung, an der die auszulesende Zelle liegt, auf ein wesentlich kleineres Potential als das Vorladepotential angehoben. Anschließend wird die Bitleitung, an der die auszulesende Zelle liegt, auf niedriges Potential abgesenkt. Sobald die MOS-Transistoren der übernächsten Zellen leitend werden, wird auch die Wortleitung auf niedriges Potential ($V_{SS}$) abgesenkt. Der Entladevorgang ist damit beendet. Nachteile dieser Entladungssteuerung sind der relativ hohe Low-Pegel des gelesenen Signals, eine hyperbolisch mit der Größe des Signals ansteigende Lesezeit und eine kritische Zeitsteuerung, da sich die Lesezeit wesentlich mit dem Signalhub verändert.

Weitere noch kompliziertere als das hier dargestellte Verfahren sind in den Veröffentlichungen von Boaz Eitan et al in IEEE Electron Device Letters 12, 450 bis 452 (1991), in IEDM 91, 311 bis 314 (1991) und in 1993 VLSITSA, 336 bis 338 (1993) beschrieben.

In der US 4,021,781 ist ein ROM mit Virtual-Ground für Taschenrechner beschrieben, bei dem eine Adressierung der Speicherplätze über eine Anordnung von Binär-Decodern erfolgt, die jeweils für eine bestimmte Anzahl von Bitleitungen vorgesehen sind. Es sind zusätzlich Transistoren vorhanden, die für eine alternative Auswahl jeweils einer der beiden Ausgangsleitungen zweier zueinander benachbarter Blöcke von Speicherplätzen vorgesehen sind.

In der US 5,117,389 ist ein ROM beschrieben, bei dem Blockauswahltransistoren für jeweils zwei benachbarte Spalten des Zellenfeldes vorgesehen sind. Diese Blockauswahltransistoren sind daher nacheinander für jede zweite Bitleitung in der Anordnung vorhanden.

Aufgabe der vorliegenden Erfindung ist es, einen Matrix-Speicher anzugeben, mit dem die obengenannten Schwierigkeiten beseitigt werden.

Diese Aufgabe wird mit dem Matrix-Speicher mit den Merkmalen des Anspruches 1 gelöst. Weitere Ausgestaltungen ergeben sich aus den abhängigen Ansprüchen.

Bei dem erfindungsgemäßen Matrix-Speicher wird anstelle einer Entladung einer einzelnen Bitleitung die gesamte Matrix aus Speicherzellen oder zumindest ein Segment dieser Matrix auf Durchgang geprüft. D. h. es wird im Prinzip festgestellt, ob ein Stromfluß quer durch den Matrix-Speicher möglich ist, wenn die einzige dafür in Frage kommende elektrische Verbindung eine auszulesende (auf die gespeicherte Information zu prüfende) Zelle und im übrigen nur untereinander kurzgeschlossene Bitleitungen umfaßt. Es werden also alle Bitleitungen bis auf die beiden zu der auszulesenden Zelle benachbarten Bitleitungen untereinander elektrisch leitend verbunden, die auszulesende Zelle wird über die betreffende Wortleitung aktiviert, und es wird versucht, von einer Ecke der Matrix oder eines Segmentes der Matrix von Zellen zu der gegenüberliegenden Ecke einen Strom zu schicken. Auf diese Weise wird geprüft, ob die betreffende Zelle leitend ist oder nicht. Es liegt bei dieser Vorgehensweise nur die auszulesende Zelle in dem gesamten Strompfad, so daß ihre Information ausgelesen werden kann, indem festgestellt wird, ob längs dieses Strompfades ein Strom fließen kann oder nicht. Hat der Transistor der betreffenden Zelle eine kleine Schwellenspannung, so hat der Strompfad Durchgang. Ist die Schwellenspannung des Transistors in dieser Zelle groß, dann bleibt der Strompfad hochohmig, und bei der angelegten Spannung fließt kein oder nur ein sehr geringer Strom.

Dazu werden zusätzliche Transistoren als Steuertransistoren eingesetzt, die alle Bitleitungen miteinander kurzschließen bis auf diejenigen beiden, zwischen denen die auszulesende Zelle liegt. Diese Steuertransistoren können auch durch eine Anordnung von Steuertransistoren als Binär-Decoder ersetzt werden, der wesentlich weniger Platz benötigt, da die Anzahl der Adreßleitungen des Binär-Decoders kleiner ist als die Anzahl der Steuerleitungen, mit denen Steuertransistoren, die zwischen zwei kurzzuschließenden Bitleitungen angeordnet sind, einzeln angesteuert werden.

Mit diesem Speicher und dem zugehörigen Ausleseverfahren erhält man die folgenden Vorteile:

1. Die gelesene Information ist eindeutig, d. h. die Durchgangsprüfung liefert nur den Informationsinhalt der gelesenen Zelle (niederohmig oder hochohmig). Die Information ist nicht abhängig von dem Zustand der Nachbarzellen.

2. Der Lesevorgang ist nicht zeitkritisch, d. h. mit der Durchgangsprüfung erhält man unabhängig von der Meßzeit immer das Ergebnis, ob der Strompfad hochohmig oder niederohmig ist. Dieses Ergebnis kann nicht mehr durch die benachbarten Speicherzellen beeinflußt werden, da sie über die Bitleitungen kurzgeschlossen sind.

Die Durchgangsprüfung kann auf verschiedene Arten durchgeführt werden:

1. Man mißt den Spannungsabfall längs des Strompfades bei einem eingeprägten Strom (konstante Stromstärke).

2. Nach dem Anlegen einer Spannung an den Strompfad wird der fließende Strom gemessen.

3. Man lädt den zu prüfenden Strompfad von beiden Seiten auf ein bestimmtes Potential auf und entlädt anschließend eines der beiden Enden. Hat der Strompfad Durchgang (niederohmige Zelle), so wird das andere Ende des Strompfades mit entladen, ansonsten bleibt das Potential an diesem Ende unverändert.

Die Verfahren nach 1. und 2. verbrauchen eine hohe Leistung. Dagegen verbraucht das dritte Verfahren nur eine sehr geringe Leistung, da für die Durchgangsprüfung nur ein Aufladen der Kapazitäten der Leitungen erforderlich ist und kein statischer Strom fließt.

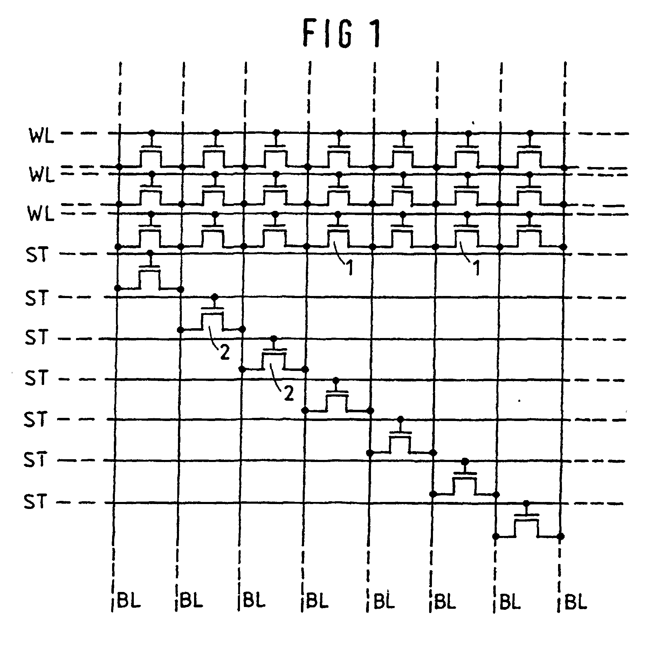

Es folgt eine genauere Beschreibung des erfindungsgemäßen Matrix-Speichers anhand der Figuren 1 bis 3, die jeweils unterschiedliche Ausführungsformen im Schema zeigen.

In den nachfolgend beschriebenen Ausführungsbeispielen sind die Speichertransistoren und die Steuertransistoren jeweils Feldeffekttransistoren. Die Speichertransistoren und/oder die Steuertransistoren können statt dessen Bipolartransistoren sein. Die Bipolartransistoren der Speicherzellen werden gleichsinnig geschaltet, d. h. in jeder Zeile des Zellenfeldes werden jeweils Emitter und Kollektor benachbarter Transistoren miteinander verbunden. Die Ansteuerung der Bipolartransistoren erfolgt über den Basis-Anschluß.

In Figur 1 ist eine matrixförmige Anordnung von Speichertransistoren 1 dargestellt. Die Source- und Drain-Anschlüsse dieser Speichertransistoren sind jeweils mit einer Bitleitung BL verbunden. Die Gate-Anschlüsse sind zeilenweise mit einer Wortleitung WL verbunden. Die Bitleitungen BL sind, abgesehen von den beiden äußeren, jeweils zwei Spalten von Speichertransistoren gemeinsam. Um diejenigen Speichertransistoren einer aktivierten Wortleitung, die nicht ausgelesen werden sollen, über die Bitleitungen kurzschließen zu können, sind Steuertransistoren 2 vorhanden, die jeweils mit Source und Drain zwischen zwei benachbarte Bitleitungen geschaltet sind und deren Gate-Anschluß jeweils mit einer Steuerleitung ST verbunden ist. Über diese Steuerleitungen ST können die Potentiale am Gate für jeden dieser Steuertransistoren 2 einzeln eingestellt werden. Es können auf diese Weise alle Steuertransistoren bis auf denjenigen, der in der Spalte der auszulesenden Zelle angeordnet ist, leitend gemacht werden. Die an die leitenden Steuertransistoren angrenzenden Bitleitungen werden dadurch kurzgeschlossen. Wenn über die betreffende Wortleitung diejenige Zeile von Zellen aktiviert wird, in der die auszulesende Zelle angeordnet ist, kann zwischen die beiden äußersten Bitleitungen eine Spannung angelegt werden und damit unmittelbar geprüft werden, ob die auszulesende Zelle leitend ist oder nicht. Das in Figur 1 dargestellte Schema ist als Ausschnitt eines erfindungsgemäßen Matrix-Speichers, der nach allen Seiten beliebig weit ausgedehnt sein kann, zu verstehen.

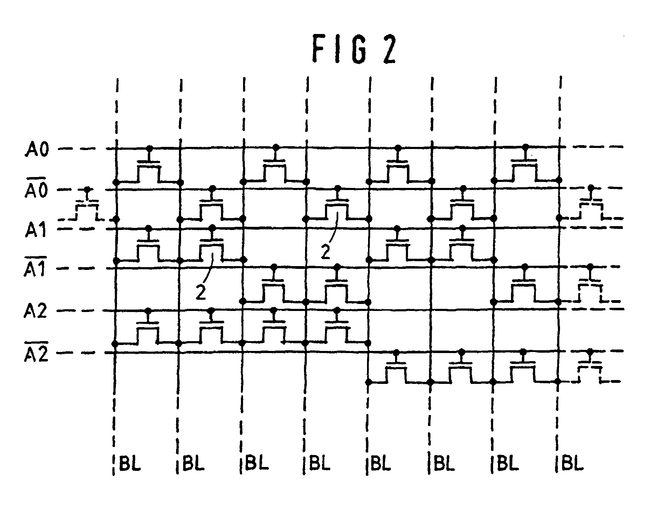

Figur 2 zeigt eine alternative Ausführung des im unteren Teil von Figur 1 dargestellten Schemas der Anordnung der Steuertransistoren. Diese Anordnung entspricht der eines Binär-Decoders. Die Steuertransistoren 2 sind so angeordnet, daß in dem Schema der Anordnung alle Zeilen paarweise vorhanden sind und in einer Zeile eines solchen Paares Steuertransistoren genau an den Stellen vorhanden sind, an denen in der zweiten Zeile dieses Paares keine Steuertransistoren vorhanden sind. Zu jeder Zeile der Anordnung von Steuertransistoren ist also eine dazu komplementäre Zeile vorgesehen. In Figur 2 sind die zu den jeweils komplementären Zeilen gehörenden Steuerleitungen mit einem Querstrich über der Bezeichnung versehen. Wenn z. B. eine Speicherzelle geprüft werden soll, die in dem Ausschnitt der Figur 2 zwischen der dritten und vierten Bitleitung von links angeordnet ist, erreicht man einen Kurzschluß aller übrigen Bitleitungen untereinander dadurch, daß die eingezeichneten Steuerleitungen $\overline{A0}$, $A1$ und $\overline{A2}$ auf ein solches Potential gelegt werden, daß die daran angeschlossenen Steuertransistoren leitend werden.

Bei einer Anordnung der Steuertransistoren gemäß Figur 2 entsprechen die Spalten dieser Anordnung den Ausgängen eines Binär-Decoders und die Steuerleitungen den Eingängen dieses Binär-Decoders. Ein solcher Binär-Decoder ist im Prinzip so aufgebaut, daß eine Gesamtheit von $2^n$ Ausgängen n-mal so unterteilt wird, daß die Teilmengen der vorhergehenden Unterteilungen jeweils halbiert werden. Es werden z. B. bei n = 4 die sechzehn Ausgänge (Nummer 1 bis Nummer 16) zunächst in zwei Teilmengen von je acht Ausgängen (Nummer 1 bis Nummer 8 und Nummer 9 bis Nummer 16) aufgeteilt, jede dieser Teilmengen in Teilmengen von je vier Ausgängen (Nummer 1 bis Nummer 4 und Nummer 5 bis Nummer 8 bzw. Nummer 9 bis Nummer 12 und Nummer 13 bis Nummer 16) unterteilt, diese Teilmengen weiter unterteilt in Teilmengen von je zwei Ausgängen (Nummer 1 und 2, Nummer 3 und 4 usw.) und dann die vierte und letzte Unterteilung auf einzelne Ausgänge vorgenommen. Ein bestimmter Ausgang läßt sich adressieren, indem in jeder dieser Unterteilungen eine Teilmenge ausgewählt wird. Es wird z. B. der fünfte Ausgang ausgewählt, indem in der ersten Unterteilung die erste Teilmenge von acht Ausgängen (Nummer 1 bis Nummer 8) ausgewählt wird. In der nachfolgenden Unterteilung dieser Teilmenge wird die zweite Teilmenge von vier Ausgängen (Nummer 5 bis Nummer 8) ausgewählt. In der sich daran anschließenden Unterteilung wird die erste Teilmenge von zwei Ausgängen (Nummer 5 und 6) ausgewählt und schließlich in der letzten Unterteilung in dieser Teilmenge der erste Ausgang ausgewählt. In dem Schema der Figur 2 wird mit der Steuerleitung A2 die links eingezeichnete Teilmenge von vier Spalten zwischen Bitleitungen kurzgeschlossen. Mit der Steuerleitung A1 werden jeweils diejenigen Bitleitungen kurzgeschlossen, zwischen denen jeweils die beiden linken Spalten einer Teilmenge von vier Spalten liegen. Die Steuerleitung $\overline{A1}$ schließt jeweils die Bitleitungen kurz, zwischen denen die jeweils rechten beiden Spalten einer solchen Teilmenge von vier Spalten liegen. Innerhalb dieser Teilmengen von zwei Spalten schließen jeweils die obere Steuerleitung A0 und die dazu komplementäre Steuerleitung $\overline{A0}$ die jeweiligen linken bzw. rechten Steuertransistoren leitend, d. h. die angrenzenden Bitleitungen miteinander kurz. Entsprechend dieser Erläuterung läßt sich eine solche Anordnung als Binär-Decoder prinzipiell für eine beliebige Anzahl von Bitleitungen vornehmen. Wenn die Anzahl der Spalten, in denen Steuertransistoren anzuordnen sind, zwischen $2^n$ und $2^{n+1}$ liegt, wird die Unterteilung in eine Teilmenge von $2^n$ Spalten und eine Teilmenge mit der restlichen Anzahl von Spalten vorgenommen. Bei den weiteren Unterteilungen verfährt man entsprechend, indem die jeweilige Anzahl gedanklich auf eine Potenz von 2 erweitert, die Teilung vorgenommen und die Anzahl der überzähligen Spalten einfach weggelassen wird.

Bei dem erfindungsgemäßen Matrix-Speicher wird nach dem oben beschriebenen Leseverfahren das gesamte Speicherzellenfeld geprüft, um eine Zelle auszulesen. Bei großen Speichern wird der Lesevorgang wegen der großen Summenkapazität und wegen des langen Strompfades langsam. Zerteilt man dagegen das Zellenfeld in kleine Segmente, so kann der Lesevorgang wesentlich beschleunigt werden. Jedes einzelne dieser Segmente ist so konzipiert wie ein Matrix-Speicher gemäß der obigen Beschreibung, z. B. entsprechend der Ausführung nach Figur 1 oder Figur 2. Vorzugsweise wird die Aufteilung des gesamten Speichers in Segmente wieder in Form einer Matrix vorgenommen. Die Segmente sind dann zeilenweise und spaltenweise innerhalb der Matrix angeordnet. Die Segmente derselben Zeile besitzen dieselbe Anzahl von Wortleitungen; die Segmente derselben Spalte besitzen dieselbe Anzahl von Bitleitungen. Beim Auslesen einer Zelle wird jeweils das gesamte Segment, in dem sich die Zelle befindet, auf Durchgang geprüft entsprechend dem oben beschriebenen Leseverfahren. Damit ein Segment ausgewählt werden kann, sind externe Bitleitungen zwischen den Segmenten vorhanden, die über Auswahltransistoren, für die ebenfalls Steuerleitungen vorgesehen sind, mit dem auszuwählenden Segment verbunden werden können.

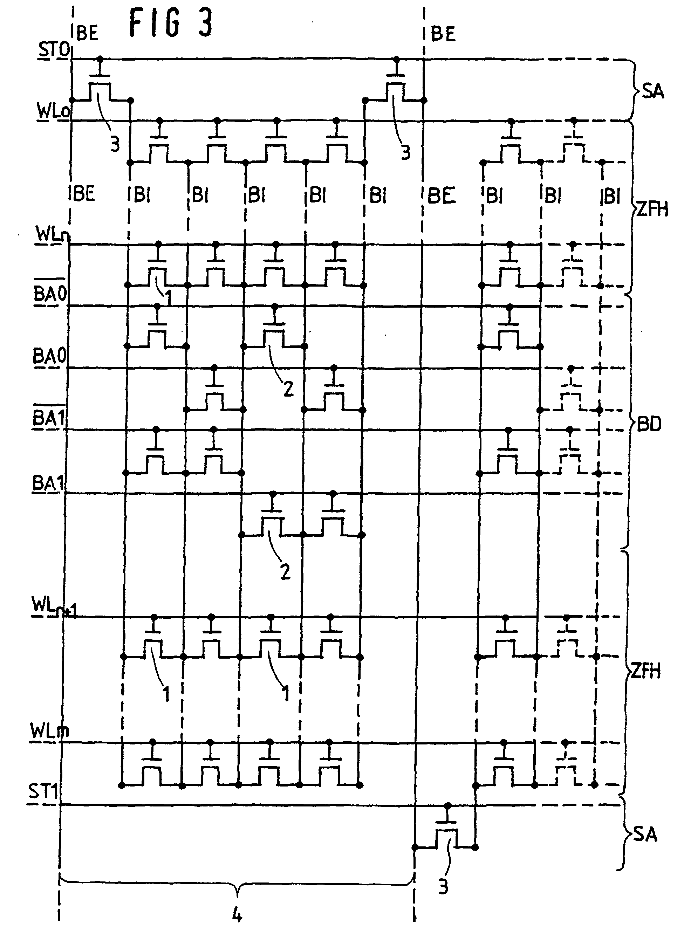

Figur 3 zeigt eine derartige Anordnung im Ausschnitt. Zwischen zwei externen Bitleitungen BE und zwei Steuerleitungen ST0, ST1 zur Auswahl eines Segmentes ist ein solches Segment 4 angeordnet. Das Schema setzt sich nach allen Seiten beliebig fort, was durch den Ansatz eines weiteren Segmentes rechts an das Segment 4 angrenzend angedeutet ist. In dem Segment 4 befinden sich die zugehörigen Speichertransistoren 1, die hier in zwei Zellenfeldhälften ZFH angeordnet sind. Zwischen diesen Zellenfeldhälften befinden sich die Steuertransistoren 2, die in diesem Beispiel als Binär-Decoder BD angeordnet sind. Die zu den Speichertransistoren führenden Wortleitungen $WL_0$, ..., $WL_n$, $WL_{n+1}$, ..., $WL_m$ sind in den Zellenfeldhälften eingezeichnet. Zur Ansteuerung des Binär-Decoders BD sind Steuerleitungen $\overline{BA0}$, $BA0$, $\overline{BA1}$, $BA1$ vorhanden. Die zu dem einzelnen Segment gehörenden Bitleitungen sind die internen Bitleitungen BI. Die Anordnung ist hier so vorgenommen, daß zwischen zwei benachbarten internen Bitleitungen jeweils Speichertransistoren 1 und zugehörige Steuertransistoren 2 angeschlossen sind. Die äußersten internen Bitleitungen des Segmentes sind jeweils nur nach einer Seite mit Speichertransistoren und Steuertransistoren verbunden. Zwischen diesen äußersten internen Bitleitungen BI wird die Durchgangsprüfung vorgenommen. Zu diesem Zweck sind die externen Bitleitungen BE auf beiden Seite des Segmentes 4 vorgesehen. Über die obere Steuerleitung ST0 werden die Feldeffekttransistoren, die als Auswahltransistoren 3 vorgesehen sind, leitend geschaltet. Diese Auswahltransistoren 3 verbinden eine äußere interne Bitleitung des Segmentes mit einer externen Bitleitung. Auf diese Weise wird das betreffende Segment für die Durchgangsprüfung ausgewählt. Der Lesevorgang im Innern des Segmentes erfolgt wie oben beschrieben. Vorzugsweise sind die externen Bitleitungen auf zwei Seiten mit Segmenten über Auswahltransistoren verbunden. Auf diese Weise kann die Auswahl der Segmente mit einer möglichst geringen Anzahl von externen Bitleitungen vorgenommen werden. Die Auswahl der Segmente über die zugehörigen Steuerleitungen ST0, ST1 erfolgt im Prinzip wie die Aktivierung von Speicherzellen über die Wortleitungen.

Mit dieser Ausführung des Matrix-Speichers gewinnt man zusätzlich zur Beschleunigung des Lesevorgangs der Information einer Zelle folgende Vorteile:

1. Gleichzeitiges paralleles Auslesen von Zellen in mehreren Segmenten ist nach einmaligem Aufladen dieser Segmente möglich. Da in jedem ausgewählten Segment eine Speicherzelle angesprochen wird, werden mehrere Zellen gleichzeitig ausgelesen. Die Informationen dieser Zellen werden parallel z. B. in einem Schieberegister abgelegt und seriell nach außen weitergegeben. Auf diese Weise erhält man eine höhere Datenrate, vor allem, wenn die Daten während des Auslesevorgangs aus dem Schieberegister herausgeschoben werden.

2. Die erforderliche dynamische, kapazitiv bedingte Leistung wird verkleinert, da auch mehrere Segmente nur einen Teil des gesamten Speichers bilden.

3. Die Potentiale der Steuertransistoren (z. B. Binär-Decoder) werden während des Vorgangs des Vorladens eingestellt, da nach dem Vorladen alle Leitungen der ausgewählten Segmente auf gleichem Potential liegen und keine Ausgleichsströme fließen können. Dies führt zu einer weiteren Zeitersparnis beim gesamten Auslesevorgang.

4. Der Platzbedarf für die Peripherieschaltung, die den Auslesevorgang steuert, sinkt sowohl in Richtung der Wortleitungen als auch in Richtung der Bitleitungen. Das ist der Fall in Richtung der Bitleitungen, da anstelle aller Bitleitungen nur die externen Bitleitungen BE (Figur 3) aus dem Zellenfeld herausgeführt werden. Das ist der Fall in Richtung der Wortleitungen, da anstelle eines Wort-Decoders für das gesamte Zellenfeld nur ein Wort-Decoder für ein Segment gebraucht wird, falls die Segmente alle über dieselbe Anzahl von Wortleitungen verfügen. Allen Segmenten können dann dieselben Wortleitungen als Auswahlleitungen zugeführt werden.

Bei der vorzugsweisen Ausgestaltung dieser segmentierten Anordnung nach Figur 3 wird jede externe Bitleitung jeweils für auf beiden Seiten benachbarte Segmente benutzt. Auf diese Weise können zahlreiche externe Bitleitungen eingespart werden. Damit über die externen Bitleitungen nicht gleichzeitig zwei benachbarte Segmente ausgewählt werden, sind für zeilenweise zueinander benachbarte Segmente jeweils verschiedene Steuerleitungen ST0, ST1 vorgesehen, die die Segmente in alternierender Folge auswählen. Die für die Auswahl des in Figur 3 gezeichneten Segmentes 4 vorgesehenen Auswahltransistoren 3 werden z. B. über die obere Steuerleitung ST0 leitend geschaltet. In dem nach rechts angrenzenden Segment sind Auswahltransistoren vorhanden, die über die untere Steuerleitung ST1 leitend geschaltet werden, so daß diese beiden benachbarten Segmente alternativ ausgewählt werden können und die gemeinsame externe Bitleitung nicht gleichzeitig von den beiden benachbarten Segmenten benutzt wird. Die für die Auswahl von Segmenten vorgesehenen Zeilen von Auswahltransistoren 3 sind in Figur 3 als Segment-Auswahlbereiche SA eingezeichnet. Die Steuertransistoren und Speichertransistoren eines Segmentes können analog zu den Schemata der Figuren 1 und 2 angeordnet sein. Ebenso können bei den Ausführungsformen der Figuren 1 und 2 die Steuertransistoren so zwischen den Speichertransistoren angeordnet sein, daß sich entsprechend Figur 3 eine Aufteilung des Matrix-Speichers in zwei Zellenfeldhälften ergibt. Eine weitergehende Unterteilung des Zellenfeldes oder von Zellenfeldsegmenten in mehrere Zellenfeldteile durch dazwischen angeordnete Steuertransistoren ist auch möglich.

**Patentansprüche**

**1.** Matrix-Speicher mit einer Unterteilung in disjunkte Segmente (4), die für sich jeweils einen Matrix-Speicher mit einer zeilen- und spaltenweisen Anordnung von Transistoren als Speichertransistoren (1) bilden,
deren Source- und Drain-Anschlüsse bzw. Emitter- und Kollektor-Anschlüsse jeweils mit einer Bitleitung (BL) und deren Gate-Anschlüsse bzw. Basis-Anschlüsse jeweils mit einer Wortleitung (WL) verbunden sind, bei dem
Transistoren als Steuertransistoren (2) vorhanden sind, deren Source- und Drain-Anschlüsse bzw. Emitter- und Kollektor-Anschlüsse jeweils mit einer dieser Bitleitungen (BL) und deren Gate-Anschlüsse bzw. Basis-Anschlüsse jeweils mit einer Steuerleitung (ST) verbunden sind, und
eine Anordnung dieser Steuertransistoren (2) derart vorgenommen ist, daß zu jedem Paar von Bitleitungen (BL), zu dem ein Speichertransistor vorhanden ist, der an beide Bitleitungen dieses Paares angeschlossen ist, eine Einstellung von an diesen Steuerleitungen (ST) anliegenden Potentialen so vorgenommen werden kann, daß ein solcher Anteil dieser Steuertransistoren leitend wird, daß durch keinen Steuertransistor eine elektrisch leitende Verbindung zwischen den Bitleitungen dieses Paares bewirkt wird und daß zu jedem weiteren Paar von Bitleitungen, zu dem ein Speichertransistor vorhanden ist,
der an beide Bitleitungen dieses weiteren Paares angeschlossen ist, durch mindestens einen Steuertransistor eine elektrisch leitende Verbindung zwischen den Bitleitungen dieses weiteren Paares bewirkt wird, und wobei der Matrix-Speicher **dadurch gekennzeichnet ist, daß** zu jeder speziellen Bitleitung (BI) eines solchen Segmentes (4), die nur mit einer anderen Bitleitung desselben Segmentes ein Paar von Bitleitungen bildet, zu dem ein Speichertransistor (1) vorhanden ist, der an beide Bitleitungen dieses Paares angeschlossen ist, eine externe Bitleitung (BE), ein Transistor als Auswahltransistor (3) und eine Steuerleitung (ST0, ST1) vorhanden sind,

der Source-Anschluß und der Drain-Anschluß bzw. der Emitter-Anschluß und der Kollektor-Anschluß dieses Auswahltransistors (3) jeweils mit dieser speziellen Bitleitung (BI) oder mit dieser externen Bitleitung (BE) verbunden ist und

der Gate-Anschluß bzw. der Basis-Anschluß dieses Auswahltransistors mit dieser Steuerleitung (ST0, ST1) verbunden ist.

2. Matrix-Speicher nach Anspruch 1, bei dem in jedem Segment zu jedem Paar von Bitleitungen (BL), zu dem ein Speichertransistor (1) vorhanden ist, der an beide Bitleitungen dieses Paares angeschlossen ist, ein Steuertransistor (2) vorhanden ist, dessen Source-Anschluß und dessen Drain-Anschluß bzw. dessen Emitter-Anschluß und dessen Kollektor-Anschluß jeweils an eine Bitleitung dieses Paares angeschlossen ist, und zu jedem Steuertransistor eine eigene Steuerleitung (ST) vorhanden ist.

3. Matrix-Speicher nach Anspruch 1, bei dem in jedem Segment die Anordnung der Steuertransistoren (ST) der eines Binär-Decoders entspricht, der so viele Ausgänge hat, wie Paare von Bitleitungen (BL), zu denen ein Speichertransistor (1) vorhanden ist, der an beide Bitleitungen eines solchen Paares angeschlossen ist, vorhanden sind.

4. Matrix-Speicher nach einem der Ansprüche 1 bis 3, bei dem in jedem Segment mit Ausnahme von zwei Bitleitungen alle Bitleitungen (BL) mit jeweils zwei anderen Bitleitungen je ein Paar von Bitleitungen bilden, zu dem ein Speichertransistor (1) vorhanden ist, der an beide Bitleitungen dieses Paares angeschlossen ist.

5. Matrix-Speicher nach einem der Ansprüche 1 bis 4, bei dem mit Ausnahme von zwei externen Bitleitungen alle externen Bitleitungen (BE) mit jeweils zwei anderen externen Bitleitungen je ein Paar von externen Bitleitungen bilden, zu dem ein Segment (4) vorhanden ist, das über Auswahltransistoren (3) an beide externen Bitleitungen dieses Paares angeschlossen ist.

6. Matrix-Speicher nach Anspruch 5, bei dem jeweils alle Auswahltransistoren (3), die mit derselben externen Bitleitung (BE) verbunden sind, mit verschiedenen Steuerleitungen (ST0, ST1) verbunden sind.

**Claims**

1. Matrix memory subdivided into disjoint segments (4), which in each case intrinsically form a matrix memory having an arrangement, in rows and columns, of transistors as memory transistors (1), the source and drain terminals and/or emitter and collector terminals of which transistors are in each case connected to a bit line (BL) and the gate terminals and/or base terminals of which transistors are in each case connected to a word line (WL), in which memory transistors are present as control transistors (2), the source and drain terminals and/or emitter and collector terminals of which transistors are in each case connected to one of these bit lines (BL) and the gate terminals and/or base terminals of which transistors are in each case connected to a control line (ST), and

these control transistors (2) are arranged in such a way that, for each pair of bit lines (BL) for which a memory transistor is present, which is connected to both bit lines of this pair, it is possible to set potentials present on these control lines (ST) in such a way that some of these control transistors are switched on such that an electrically conductive connection between the bit lines of this pair is effected by no control transistor and that, for each further pair of bit lines for which a memory transistor is present, which is connected to both bit lines of this further pair, an electrically conductive connection between the bit lines of this further pair is effected by at least one control transistor, and where the matrix memory is **characterized in that** for each specific bit line (BI) of such a segment (4), which bit line forms a pair of bit lines only with another bit line of the same segment, for which pair a memory transistor (1) is present which is connected to both bit lines of this pair, an external bit line (BE), a transistor in the form of a selection transistor (3) and a control line (ST0, ST1) are present,

the source terminal and the drain terminal or the emitter terminal and the collector terminal of this selection transistor (3) are in each case connected to this specific bit line (BI) or to this external bit line (BE), and

the gate terminal or the base terminal of this selection transistor is connected to this control line (ST0, ST1).

2. Matrix memory according to Claim 1, in which each segment contains a control transistor (2) for each pair of bit lines (BL) for which a memory transistor (1) is present, which is connected to both bit lines of this pair, the source terminal and drain terminal or emitter terminal and collector terminal of which control transistor are in each case connected to one bit line of this pair, and each control transistor is provided with a dedicated control line (ST).

**3.** Matrix memory according to Claim 1, in which, in each segment, the arrangement of the control transistors (ST) corresponds to that of a binary decoder which has as many outputs as there are pairs of bit lines (BL) for which a memory transistor (1) is present, which is connected to both bit lines of such a pair.

**4.** Matrix memory according to one of Claims 1 to 3, in which, in each segment, all of the bit lines (BL), with the exception of two bit lines, form with two respective other bit lines in each case a pair of bit lines for which a memory transistor (1) is present, which is connected to both bit lines of this pair.

**5.** Matrix memory according to one of Claims 1 to 4, in which, with the exception of two external bit lines, all of the external bit lines (BE) form with two respective other external bit lines in each case a pair of external bit lines for which a segment (4) is present, which is connected via selection transistors (3) to both external bit lines of this pair.

**6.** Matrix memory according to Claim 5, in which all of the selection transistors (3) which are connected to the same external bit line (BE) are in each case connected to different control lines (ST0, ST1).

**Revendications**

**1.** Matrice mémoire avec une division en segments disjoints (4) qui forment chacun une matrice mémoire avec une disposition en lignes et en colonnes de transistors servant de transistors de mémorisation (1),

dont les bornes de source et de drain ou les bornes d'émetteur et de collecteur sont reliées respectivement à un conducteur de bits (BL) et dont les bornes de grille ou les bornes de base sont reliées respectivement à un conducteur de mots (WL),

dans laquelle il y a des transistors comme transistors de commande (2) dont les bornes de source et de drain ou les bornes d'émetteur et de collecteur sont reliées respectivement à l'un de ces conducteurs de bits (BL) et dont les bornes de grille ou les bornes de base sont reliées respectivement à un conducteur de commande (ST), et

dans laquelle une disposition de ces transistors de commande (2) est mise en oeuvre de telle sorte que, pour chaque paire de conducteurs de bits (BL) pour laquelle il y a un transistor de mémorisation qui est raccordé aux deux conducteurs de bits de cette paire, un réglage de potentiels appliqués à ces conducteurs de commande (ST) est effectué de telle sorte qu'une proportion telle de ces transistors de commande devient conductrice qu'il n'est pas provoqué par un transistor de commande une liaison électriquement conductrice entre les conducteurs de bits de cette paire et que, pour chaque autre paire de conducteurs de bits pour laquelle il y a un transistor de mémorisation qui est raccordé aux deux conducteurs de bits de cette autre paire, il est provoqué par au moins un transistor de commande une liaison électriquement conductrice entre les conducteurs de bits de cette autre paire, et dans laquelle la matrice de mémoire est **caractérisée par le fait que** pour chaque conducteur de bits spécial (Bl) d'un segment de ce genre (4), lequel conducteur de bits forme seulement avec un autre conducteur de bits du même segment une paire de conducteurs de bits pour laquelle il existe un transistor de mémorisation (1) qui est raccordé aux deux conducteurs de bits de cette paire, il y a un conducteur de bits externe (BE), un transistor comme transistor de sélection (3) et un conducteur de commande (ST0, ST1),

la borne de source et la borne de drain ou la borne d'émetteur et la borne de collecteur de ce transistor de sélection (3) est reliée respectivement à ce conducteur de bits spécial (Bl) ou à ce conducteur de bits externe (BE) et la borne de grille ou la borne de base de ce transistor de sélection est reliée à ce conducteur de commande (ST0, ST1).

**2.** Matrice mémoire selon la revendication 1, dans laquelle il y a dans chaque segment pour chaque paire de conducteurs de bits (BL) pour laquelle il existe un transistor de mémorisation (1) qui est raccordé aux deux conducteurs de bits de cette paire un transistor de commande (2) dont la borne de source et la borne de drain ou la borne d'émetteur et la borne de collecteur est raccordée respectivement à un conducteur de bits de cette paire et il existe pour chaque transistor de commande un conducteur de commande (ST) particulier.

**3.** Matrice mémoire selon la revendication 1, dans laquelle dans chaque segment le dispositif des transistors de commande (ST) correspond à celui d'un décodeur binaire qui a autant de sorties qu'il y a de paires de conducteurs de bits (BL) pour lesquelles il existe un transistor de mémorisation (1) qui est raccordé aux deux conducteurs de bits d'une paire de ce genre.

**4.** Matrice mémoire selon l'une des revendications 1 à 3, dans laquelle dans chaque segment, à l'exception de deux conducteurs de bits, tous les conducteurs de bits (BL) forment avec respectivement deux autres conducteurs de bits une paire de conducteurs de bits pour laquelle il existe un transistor de mémorisation (1) qui est raccordé aux deux conducteurs de bits de cette paire.

**5.** Matrice mémoire selon l'une des revendications 1 à 4, dans laquelle à l'exception de deux conducteurs de bits externes tous les conducteurs de bits externes (BE) forment avec respectivement deux autres conducteurs de bits externes une paire de conducteurs de bits externes pour laquelle il existe un segment (4) qui est raccordé par l'intermédiaire de transistors de sélection (3) aux deux conducteurs de bits externes de cette paire.

**6.** Matrice mémoire selon la revendication 5, dans laquelle, respectivement, tous les transistors de sélection (3) qui sont reliés au même conducteur de bits externe (BE) sont reliés à des conducteurs de commande différents (ST0, ST1).

# FIG 1

# F I G 2

FIG 3